# EUROPÄISCHE PATENTSCHRIFT

(11) **EP 1 119 858 B1**
(45) Veröffentlichungstag und Bekanntmachung des Hinweises auf die Patenterteilung: **05.02.2003**
(21) Anmeldenummer: 99950445.9
(22) Anmeldetag: 28.07.1999
(51) Int. Cl.: G11C 8/00, H03K 19/094

(54) **DECODERELEMENT ZUR ERZEUGUNG EINES AUSGANGSSIGNALS MIT DREI UNTERSCHIEDLICHEN POTENTIALEN UND BETRIEBSVERFAHREN FÜR DAS DECODERELEMENT**
DECODER ELEMENT FOR PRODUCING AN OUTPUT SIGNAL WITH THREE DIFFERENT POTENTIALS AND OPERATING METHOD FOR SAID DECODER ELEMENT
ELEMENT DECODEUR PERMETTANT DE PRODUIRE UN SIGNAL DE SORTIE AVEC TROIS POTENTIELS DIFFERENTS ET MODE DE FONCTIONNEMENT DE CET ELEMENT DECODEUR

(30) Priorität: 29.09.1998 DE 19844666
(43) Veröffentlichungstag der Anmeldung: 01.08.2001
(73) Patentinhaber: Infineon Technologies AG, 81669 München (DE)
(72) Erfinder: RÖHR, Thomas, D-82178 Puchheim (DE); HÖNIGSCHMID, Heinz, D-82319 Starnberg (DE); MANYOKI, Zoltan, D-81739 München (DE); BÖHM, Thomas, D-85604 Zorneding (DE); NEUHOLD, Ernst, A-8052 Graz (AT); BRAUN, Georg, D-80339 München (DE)
(74) Vertreter: Kottmann, Heinz Dieter, Dipl.-Ing.
(86) Internationale Anmeldenummer: DE9902321
(87) Internationale Veröffentlichungsnummer: WO00019436

(56) Entgegenhaltungen:
- EP-A- 0 352 937

## Beschreibung

Die Erfindung betrifft ein Decoderelement zur Erzeugung eines Ausgangssignal mit drei unterschiedlichen Potentialen sowie ein Betriebsverfahren für das Decoderelement.

Der Erfindung liegt die Aufgabe zugrunde, ein Decoderelement anzugeben, das an einem Ausgang ein Ausgangssignal erzeugt, das in Abhängigkeit von Eingangssignalen des Decoderelementes drei unterschiedliche Potentiale annehmen kann.

Diese Aufgabe wird mit einem Decoderelement gemäß Patentanspruch 1 gelöst. Mit zwei deratigen Decoderelementen, deren dritte Anschlüsse miteinander verbunden sind, läßt sich vorteilhaft eine Decoderschaltung realisieren.

Mit dem Betriebsverfahren nach Anspruch 5 wird vorteilhaft eines der Potentiale des Ausgangssignals erzeugt.

Die Erfindung wird im folgenden anhand der Figuren näher erläutert.
- Figur 1: zeigt ein Ausführungsbeispiel des Decoderelementes,
- Figur 2: zeigt ein Ausführungsbeispiel einer Decoderschaltung mit zwei Decoderelementen aus Figur 1 und
- Figur 3: zeigt die Abhängigkeit von Potentialen am Ausgang eines der Decoderelemente von Potentialen ihrer Eingangssignale.

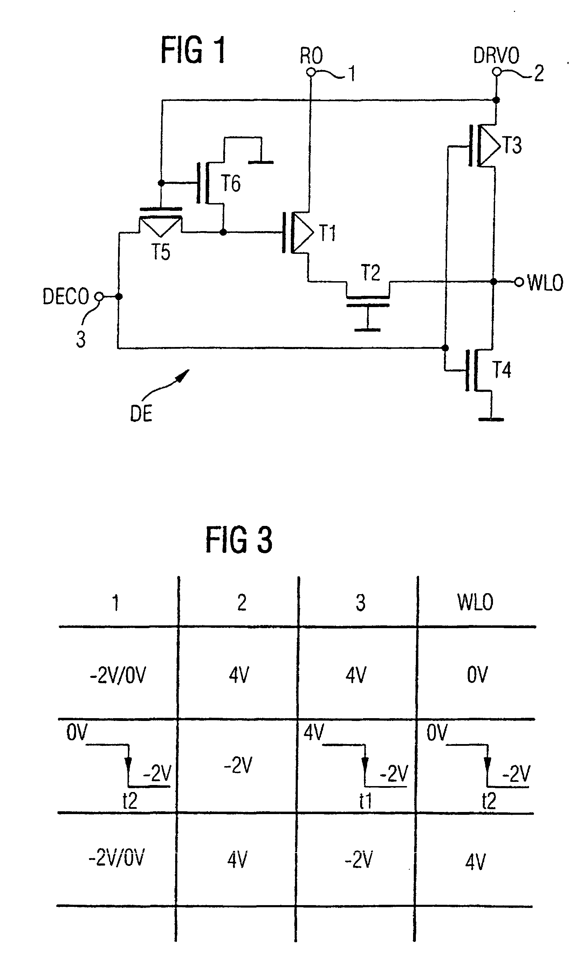

Figur 1 zeigt ein erfindungsgemäßes Decoderelement DE. Zwischen einem ersten Anschluß 1 und einem Ausgang WL0 ist eine Reihenschaltung eines Transistors T1 vom p-Kanal-Typ und eines zweiten Transistors T2 vom n-Kanal-Typ angeordnet. Das Gate des zweiten Transistors T2 ist mit Masse (0 Volt) verbunden. Weiterhin ist zwischen einem zweiten Anschluß 2 und Masse eine Reihenschaltung eines dritten Transistors T3 vom p-Kanal-Typ und eines vierten Transistors 4 vom n-Kanal-Typ angeordnet. Die Drains des dritten T3 und vierten T4 Transistors sind mit dem Ausgang WL0 verbunden. Ein dritter Anschluß 3 ist mit dem Gate des dritten Transistors T3 und des vierten Transistors T4 verbunden. Außerdem ist der dritte Anschluß 3 über einen fünften Transistors T5 vom p-Kanal-Typ mit dem Gate des ersten Transistors T1 verbunden. Das Gate des ersten Transistors T1 ist auch über einen sechsten Transistors T6 vom n-Kanal-Typ mit Masse verbunden. Die Gates des fünften Transistors T5 und sechsten Transistors T6 sind mit dem zweiten Anschluß 2 verbunden. Die Funktion des Decoderelementes DE in Figur 1 wird im folgenden anhand Figur 3 erläutert.

Figur 3 ist zu entnehmen, daß am Ausgang WL0 des Decoderelements DE aus Figur 1 in Abhängigkeit von Potentialen an den Anschlüssen 1, 2, 3 drei unterschiedliche Potentiale erzeugt werden, nämlich 0 Volt, -2 Volt und 4 Volt. Um am Ausgang WL0 ein Potential von 0 Volt zu erzeugen, liegt am zweiten Anschluß und am dritten Anschluß 4 Volt an und am ersten Anschluß 1 -2 Volt oder 0 Volt. Dann ist der dritte Transistor T3 gesperrt und der vierte Transistor T4 leitend, so daß der Ausgang WL0 über letzteren leitend mit Masse verbunden ist. Da am Gate des zweiten Transistors T2 Masse anliegt, ist dieser Transistor gesperrt. Die 4 Volt am zweiten Anschluß 2 sperren auch den fünften Transistor T5 und schalten den sechsten Transistor T6 leitend, so daß über letzteren am Gate des ersten Transistors T1 Masse anliegt. Da das Potential am ersten Anschluß 1 kleiner oder gleich dem Gatepotential des ersten Transistors T1 ist, sperrt auch dieser.

Um am Ausgang WL0 ein Potential von -2 Volt zu erzeugen, wird das Decoderelement DE in Figur 1 zunächst in einen Ausgangszustand versetzt, in dem am ersten Anschluß 1 0 Volt, am zweiten Anschluß 2 -2 Volt und am dritten Anschluß 3 4 Volt anliegen. Es ist günstig, wenn zuvor bereits am ersten Anschluß 1 0 Volt am zweiten Anschluß 2 4 Volt und am dritten Anschluß 3 4 Volt anliegen, so daß zunächst am Ausgang WL0 ein Potential von 0 Volt erzeugt wird (siehe erste Zeile der Tabelle in Figur 3). Wenn das Potential am zweiten Anschluß 2 dann von 4 Volt auf -2 Volt wechselt, bleibt am Ausgang WL0 zunächst das Potential von 0 Volt erhalten, da der dritte Transistor T3 nach wie vor sperrt und der vierte Transistor T4 nach wie vor leitend. Die -2 Volt am zweiten Anschluß bewirken, daß der sechste Transistor T6 sperrt und der fünfte Transistor T5 die 4 Volt am dritten Anschluß mit dem Gate des ersten Transistors T1 verbindet. Dadurch bleibt der erste Transistor T1 zunächst weiter gesperrt.

Zu einem ersten Zeitpunkt t1 weist das Potential am dritten Anschluß 3 eine negative Flanke von 4 Volt auf -2 Volt auf. Dadurch wird der vierte Transistor T4 gesperrt, so daß der Ausgang WL0 von Masse getrennt wird. Der dritte Transistor T3 bleibt weiterhin gesperrt, da seine Gate-Source-Spannung 0V beträgt. Da der fünfte Transistor T5 während der fallenden Flanke des Potentials am dritten Anschluß 3 zunächst noch leitend bleibt, sinkt das Gatepotential des ersten Transistors T1 zunächst mit dem Potential am dritten Anschluß 3 ab. Der fünfte Transistor T5 sperrt erst, wenn seine Gate-Source-Spannung kleiner als seine Einsatzspannung wird. Im vorliegenden Fall beträgt die Einsatzspannung des fünften Transistors T5 0,7 Volt. Somit sinkt das Gatepotential des ersten Transistors T1 in Folge der negativen Flanke des Potentials am dritten Anschluß 3 bis auf -2 Volt + 0,7 Volt = -1,3 Volt ab, bevor der fünfte Transistor T5 sperrt.

Zu einem zweiten Zeitpunkt t2 nach dem ersten Zeitpunkt t1 weist das Potential am ersten Anschluß 1 eine negative Flanke von 0 Volt auf -2 Volt auf. Da zu diesem Zeitpunkt sowohl der fünfte Transistor T5 als auch der sechste Transistor T6 gesperrt sind, sinkt das Gatepotential des ersten Transistors T1 aufgrund eines nun erfolgenden Bootstrap-Effektes mit dem Potential am ersten Anschluß 1 weiter ab. Auf diese Weise erreicht das Gatepotential des ersten Transistors T1 einen Wert von ca. -1,3 Volt - 2 Volt = -3,3 Volt bis zu dem Zeitpunkt, zu dem die negative Flanke des Potentials am ersten Anschluß 1 endet (in Figur 3 sind die fallenden Flanken mit unendlicher Steilheit eingetragen. In Wirklichkeit haben sie eine endliche Steigung, so daß ein allmählicher Potentialwechsel erfolgt). Sobald am Gate des ersten Transistors T1 ein Potential anliegt, das um wenigstens die Einsatzspannung dieses Transistors unterhalb des Potentials am ersten Anschluß liegt, leitet der erste Transistor T1, so daß die Potentiale an seiner Drain und seiner Source übereinstimmen. Daher weist das Potential am Ausgang WL0 zeitgleich zur fallenden Flanke des Potentials am ersten Anschluß 1 eine fallende Flanke ebenfalls von 0 Volt auf -2 Volt auf. Der zweite Transistor T2 verbindet nämlich das negative Potential an der Drain des ersten Transistors T1 leitend mit dem Ausgang WL0, da an seinem Gate Masse anliegt. Die fallende Flanke am Ausgang WL0 beginnt auch nahezu zum zweiten Zeitpunkt t2.

Um schließlich das dritte Potential von 4 Volt am Ausgang WL0 zu erzeugen, liegt am ersten Anschluß 1 entweder -2 Volt oder 0 Volt, am zweiten Anschluß 4 Volt und am dritten Anschluß 3 -2 Volt an (siehe letzte Zeile der Tabelle in Figur 3). Die 4 Volt am zweiten Anschluß 3 sorgen dafür, daß der fünfte Transistor T5 sperrt und der sechste Transistor T6 das Gate vom ersten Transistor T1 mit Masse verbindet. Somit ist der erste Transistor T1 sicher gesperrt. Die -2 Volt am dritten Anschluß 3 bewirken, daß der vierte Transistor T4 sperrt und der dritte Transistor T3 leitend ist. Somit liegen die 4 Volt vom zweiten Anschluß 2 am Ausgang WL0 an.

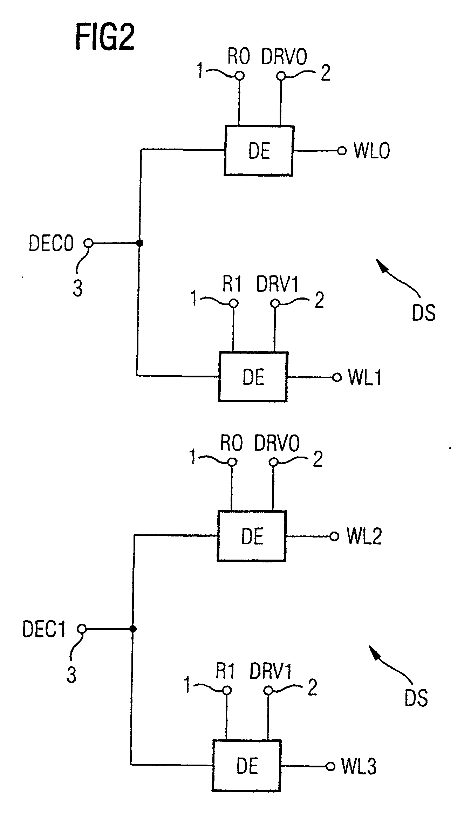

Figur 2 ist einer Decoderanordnung zu entnehmen, die jeweils zwei Decoderschaltungen DS aufweist, von denen jede zwei Decoderelemente DE von der in Figur 1 dargestellten Art aufweisen. Dem jeweils oberen Decoderelement DE der Decoderschaltungen DS in Figur 2 wird am ersten Anschluß 1 ein gemeinsames erstes Signal R0 und am zweiten Anschluß 2 ein gemeinsames zweites Signal DRV0 zugeführt. Den unteren Decoderelementen DE der Decoderschaltungen DS wird am ersten Anschluß 1 ein gemeinsames erstes Signal R1 und am zweiten Anschluß 2 ein gemeinsames zweites Signal DRV1 zugeführt. Die dritten Anschlüsse 3 jeder Decoderschaltung DS sind miteinander verbunden. Ihnen wird pro Decoderschaltung DS ein separates drittes Signal DECO, DEC1 zugeführt. Die ersten Signale R0, R1, die zweiten Signale DRV0, DRV1 und die dritten Signale DEC0, DEC1 der Decoderschaltungen DS weisen zur Erzeugung des gewünschten Ausgangspotentials an den Ausgängen Wli die in Figur 3 dargestellten Potentiale beziehungsweise Potentialverläufe auf.

Es ist deutlich, daß die Decoderanordnung in Figur 2 problemlos um weitere Decoderschaltungen DS ergänzt werden kann, wobei pro Decoderschaltung lediglich ein separates drittes Signal DECi notwendig ist. Auf diese Weise erhält man eine Decoderanordnung mit einer beliebigen Anzahl von Ausgängen WLi. Liegt am dritten Anschluß einer der Decoderschaltungen DS permanent 4 Volt an, ist diese Decoderschaltung deaktiviert, so daß an ihren Ausgängen Wli ständig 0 Volt anliegen. Weist dagegen das Potential am dritten Anschluß 3 der Decoderschaltung DS eine negative Flanke von 4 Volt auf -2 Volt auf, kann durch die Wahl der Potentialverläufe am ersten Anschluß 1 und am zweiten Anschluß 2 bestimmt werden, an welchem ihrer Ausgänge WLi -2 Volt und an welchem 4 Volt erzeugt werden sollen.

Die in Figur 2 gezeigte Decoderanordnung eignet sich beispielsweise als Bestandteil eines Wortleitungsdecoders eines integrierten Speichers, bei dem die Ausgänge WLi der Decoderelemente DE mit je einer Wortleitung verbunden sind und das erste Signal R0, R1, das zweite Signal DRV0, DRV1 und das dritte Signal DEC0, DEC1 ihre Potentiale in Abhängigkeit von an den Speicher angelegten Wortleitungsadressen ändern.

## Patentansprüche

1. Decoderelement (DE) zur Erzeugung eines Ausgangssignals mit drei unterschiedlichen Potentialen (-2V, 0V, 4V) an einem Ausgang (WLi), wobei das zweite Potential (0V) zwischen dem ersten (-2V) und dem dritten (4V) Potential liegt,
- mit einem ersten Anschluß (1), der über eine Reihenschaltung aus einem ersten Transistor (T1) eines ersten Leitungstyps und einem zweiten Transistor (T2) eines zweiten Leitungstyps mit dem Ausgang (WLi) verbunden ist, wobei ein Steueranschluß des zweiten Transistors (T2) mit dem zweiten Potential (0V) verbunden ist,
- mit einem zweiten Anschluß (2), der über einen dritten Transistor (T3) des ersten Leitungstyps mit dem Ausgang (WLi) verbunden ist,
- dessen Ausgang (WLi) über einen vierten Transistor (T4) des zweiten Leitungstyps mit dem zweiten Potential (0V) verbunden ist,
- mit einem dritten Anschluß (3), der mit Steueranschlüssen des dritten (T3) und des vierten (T4) Transistors verbunden ist und der über einen fünften Transistor (T5) des ersten Leitungstyps mit einem Steueranschluß des ersten Transistors (T1) verbunden ist.
- und mit einem sechsten Transistor (T6) des zweiten Leitungstyps, über den der Steueranschluß des ersten Transistors (T1) mit dem zweiten Potential (0V) verbunden ist,
- bei dem der zweite Anschluß (2) mit Steueranschlüssen des fünften (T5) und des sechsten (T6) Transistors verbunden ist.

2. Decoderelement nach Anspruch 1,
bei dem zur Erzeugung des Ausgangssignals mit dem zweiten Potential (OV) am ersten Anschluß (1) das erste (-2V) oder das zweite (0V) Potential sowie am zweiten Anschluß (2) und am dritten Anschluß (3) das dritte Potential (4V) anliegt.

3. Decoderelement nach Anspruch 1,
bei dem zur Erzeugung des Ausgangssignals mit dem dritten Potential (4V) am ersten Anschluß (1) das erste (-2V) oder das zweite (0V) Potential, am zweiten Anschluß (2) das dritte Potential (4V) und am dritten Anschluß (3) das erste Potential (-2V) anliegt.

4. Decoderschaltung (DC) mit zwei Decoderelementen (DE) nach Anspruch 1 oder 2,
bei der die dritten Anschlüsse (3) der Decoderelemente (DE) miteinander verbunden sind.

5. Betriebsverfahren für ein Decoderelement nach Anspruch 1, bei dem zur Erzeugung des Ausgangssignals mit dem ersten Potential (-2V) zunächst am zweiten Anschluß (2) das erste Potential (-2V) angelegt wird, anschließend am dritten Anschluß (3) ein Wechsel vom dritten (4V) auf das erste (-2V) Potential durchgeführt wird und daraufhin am ersten Anschluß (1) ein Wechsel vom zweiten (0V) zum ersten (-2V) Potential durchgeführt wird.

## Claims

1. Decoder element (DE) for generating an output signal with three different potentials (-2V,0V,4V) at an output (WLi), the second potential (0V) lying between the first potential (-2V) and the third potential (4V),
- having a first terminal (1) which is connected to the output (WLi) via a series circuit composed of a first transistor (T1) of a first conduction type and of a second transistor (T2) of a second conduction type, one control terminal of the second transistor (T2) being connected to the second potential (0V),
- having a second terminal (2) which is connected to the output (WLi) via a third transistor (T3) of the first conduction type,
- the output (WLi) of which is connected to the second potential (0V) via a fourth transistor (T4) of the second conduction type,
- having a third terminal (3) which is connected to the control terminals of the third transistor (T3) and of the fourth transistor (T4), and which is connected via a fifth transistor (T5) of the first conduction type to a control terminal of the first transistor (T1),
- and having a sixth transistor (T6) of the second conduction type via which the control terminal of the first transistor (T1) is connected to the second potential (0V),
- in which the second terminal (2) is connected to control terminals of the fifth transistor (T5) and of the sixth transistor (T6).

2. Decoder element according to Claim 1, in which, in order to generate the output signal with the second potential (0V), the first potential (-2V) or the second potential (0V) is present at the first terminal (1), and the third potential (4V) is present at the second terminal (2) and at the third terminal (3).

3. Decoder element according to Claim 1, in which, in order to generate the output signal with the third potential (4V), the first potential (-2V) or the second potential (0V) is present at the first terminal (1), the third potential (4V) is present at the second terminal (2) and the first potential (-2V) is present at the third terminal (3).

4. Decoder circuit (DC) having two decoder elements (DE) according to Claim 1 or 2, in which the third terminals (3) of the decoder elements (DE) are connected to one another.

5. Operating method for a decoder element according to Claim 1, in which, in order to generate the output signal with the first potential (-2V), the first potential (-2V) is firstly applied to the second terminal (2), then a change-over from the third potential (4V) to the first potential (-2V) is carried out at the third terminal (3), and subsequently a change-over from the second potential (0V) to the first potential (-2V) is carried out at the first terminal (1).

## Revendications

1. Elément (DE) décodeur de production d'un signal de sortie ayant trois potentiels (-2V, 0V, 4V) différents sur une sortie (WLi), le deuxième potentiel (0V) étant compris entre le premier potentiel (-2V) et le troisième potentiel (4V),
- comprenant une première borne (1) qui est reliée à la sortie (WLi) par un circuit série constitué d'un premier transistor (T1) d'un premier type de conductivité et d'un deuxième transistor (T2) d'un deuxième type de conductivité, une borne de commande du deuxième transistor (T2) étant reliée au deuxième potentiel (0V),
- comprenant une deuxième borne (2) qui est reliée par un troisième transistor (T3) du premier type de conductivité à la sortie (WLi),
- dont la sortie (WLi) est reliée par un quatrième transistor (T4) du deuxième type de conductivité au deuxième potentiel (0V),
- comprenant une troisième borne (3) qui est reliée à des bornes de commande du troisième transistor (T3) et du quatrième transistor (T4) et qui est reliée par un cinquième transistor (T5) du premier type de conductivité à une borne de commande du premier transistor (T1),
- et comprenant un sixième transistor (T6) du deuxième type de conductivité par lequel la borne de commande du premier transistor (T1) est reliée au deuxième potentiel (0V),
- dans lequel la deuxième borne (2) est reliée à des bornes de commande du cinquième transistor (T5) et du sixième transistor (T6).

2. Elément décodeur suivant la revendication 1,
dans lequel pour produire le signal de sortie ayant le deuxième potentiel (0V), il est appliqué sur la première borne (1) le premier potentiel (-2V) ou le deuxième potentiel (0V), ainsi que sur la deuxième borne (2) et sur la troisième borne (3) le troisième potentiel (4V).

3. Elément décodeur suivant la revendication 1,
dans lequel pour produire le signal de sortie ayant le troisième potentiel (4V), il est appliqué sur la première borne (1) le premier potentiel (-2V) ou le deuxième potentiel (0V), sur la deuxième borne (2) le troisième potentiel (4V) et sur la troisième borne (3) le premier potentiel (-2V).

4. Circuit (DC) décodeur ayant deux éléments (DE) décodeurs suivant la revendication 1 ou 2,
dans lequel les troisièmes bornes (3) des éléments (DE) décodeurs sont reliées entre elles.

5. Procédé pour faire fonctionner un élément décodeur suivant la revendication 1, qui consiste à appliquer, pour produire le signal de sortie ayant le premier potentiel (-2V), d'abord le premier potentiel (-2V) à la deuxième borne (2), à effectuer ensuite sur la troisième borne (3) un passage du troisième potentiel (4V) au premier potentiel (-2V), et ensuite à effectuer sur la première borne (1) un passage du deuxième potentiel (0V) au premier potentiel (-2V).
